(19) Europäisches Patentamt
European Patent Office
Office européen des brevets

(11) EP 2 412 737 A1

(12) **EUROPEAN PATENT APPLICATION**
published in accordance with Art. 153(4) EPC

(43) Date of publication:
**01.02.2012 Bulletin 2012/05**

(21) Application number: **10755729.0**

(22) Date of filing: **08.01.2010**

(51) Int Cl.:
***C08F 293/00*** *(2006.01)*

(86) International application number:
**PCT/JP2010/050121**

(87) International publication number:
**WO 2010/109928 (30.09.2010 Gazette 2010/39)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **24.03.2009 JP 2009071296**

(71) Applicant: **Maruzen Petrochemical CO., LTD.**
**Tokyo 104-8502 (JP)**

(72) Inventor: **YOSHIDA Norihiro**
**Ichihara-shi**
**Chiba 290-8503 (JP)**

(74) Representative: **Adam, Holger**
**Kraus & Weisert**
**Patent- und Rechtsanwälte**
**Thomas-Wimmer-Ring 15**
**80539 München (DE)**

# (54) VINYL ETHER-BASED STAR POLYMER AND PROCESS FOR PRODUCTION THEREOF

(57) Provided is a vinyl ether-based star polymer which has an arm including a vinyl ether polymer and an arm including an oxystyrene polymer. Also provided is a process for producing the star polymer, which can be continuously carried out in a series of steps. Said vinyl ether-based star polymer and process for producing the same are such that the polymer includes a core and polymer-chain arm portions extending from the core, in which an arm portion including vinyl ether repeating units and an arm portion including oxystyrene repeating units are provided.

EP 2 412 737 A1

## Description

Technical Field

The present invention relates to a novel vinyl ether-based star polymer and a process for producing the same. More particularly, the invention is concerned with a star polymer having a vinyl ether polymer and an oxystyrene polymer in arm portions and a process for producing the same.

Background Art

Oxystyrene polymers including hydroxystyrene are used as functional polymer materials in various fields of industry, and, especially in the field of electronic materials, they are used particularly as raw materials for the resin component of a semiconductor resist. Further, the utilization of the oxystyrene polymer as a photosensitive resin component for use in an interlayer dielectric film or surface protecting film for a semiconductor device and the like is being studied.

In recent years, semiconductor devices are increased in the integration degree and size, resin encapsulation packages are reduced in the thickness and size, and the mounting method is shifted toward the surface mount by reflow soldering. Therefore, it is desired that the oxystyrene polymer has further improved physical properties and has novel physical properties imparted thereto, and an attempt is made to introduce the oxystyrene polymer into a polymer having a special structure, such as a block polymer or a star polymer.

Especially, with respect to a star polymer having both the oxystyrene polymer and another polymer in arms, both characteristic properties of the star polymer, such as low viscosity and fine particle properties, and inherent functions of the oxystyrene polymer and another polymer can be imparted to the polymer, and hence such a star polymer can be preferably used as a raw material for a photosensitive resin component suitable for the use of an interlayer dielectric film, surface protecting film, or the like for a semiconductor device.

For example, patent document 1 discloses a method for producing a star polymer having in arms at least one type of repeating units selected from the group consisting of an oxystyrene polymer, an acrylic acid-methacrylic acid polymer, a norbornene polymer, a tetracyclodecene polymer, and a maleimide polymer. In addition, patent document 2 discloses a method for producing a star polymer comprising an oxystyrene polymer and an acrylic acid-methacrylic acid polymer.

However, in patent document 1, only a specific synthesis of a star polymer having a methacrylic acid polymer in arms is shown, and, in patent document 2, only a specific synthesis of a star polymer having an oxystyrene polymer in arms is shown, and these patent documents have no description about the method for introducing both the above polymers into the arms of the star polymer.

On the other hand, patent document 3 discloses a method for producing a star polymer having an alkenylphenol polymer and a methacrylic polymer in arms, wherein the method comprises subjecting an alkenylphenol to anionic polymerization in the presence of an anionic polymerization initiator to synthesize arms, and then reacting a multifunctional coupling agent with the arms, and further reacting a methacrylic monomer with the arms. However, in this method, a monomer having no anionic polymerizability cannot be introduced to the arms.

Further, the star polymer having an acrylic polymer in arms has problems in that the water resistance and electric properties are poor. For this reason, the production of a star polymer having arms comprising a combination of an oxystyrene polymer and a polymer other than the acrylic polymer is desired.

By the way, there can be mentioned a number of polymers usable as a substitute for the acrylic polymer, and among them, a vinyl ether polymer has attracted attention as a polymer which has fluidity equivalent to that of the acrylic polymer and does not lower the electric properties, and is being applied to the star polymer.

For example, patent document 4 discloses a method for producing a vinyl ether-based star polymer, wherein the method comprises subjecting a vinyl ether to living cationic polymerization using an initiator comprising a combination of a protonic acid and a Lewis acid, and then adding a divinyl ether to the resultant living polymer.

Patent document 5 discloses a method for producing a vinyl ether-based star polymer having response properties, wherein the method comprises subjecting a vinyl ether to living cationic polymerization using an initiator species, such as an alkoxyethyl acetate, and a Lewis acid, and then adding a divinyl ether to the resultant living polymer.

Further, in non-patent document 1, a vinyl ether is subjected to living cationic polymerization using an initiator comprising a combination of a monofunctional initiator and a Lewis acid, and then a divinyl ether is added to the resultant living polymer to form a core, and a vinyl ether different from that used above is reacted with the core so that the different vinyl ether chains extend from the core, thus synthesizing a heteroarm star polymer.

Each of the star polymers described in patent documents 4 and 5 and non-patent document 1 is, however, a star polymer comprising only a vinyl ether polymer, and there is no report of the star polymer comprising both the vinyl ether polymer and oxystyrene polymer.

Patent document 6 discloses a method for synthesizing a star polymer having an arm comprising a block polymer of a vinyl ether polymer and an oxystyrene polymer by a core-first method using a multifunctional initiator species. However, a vinyl ether and an oxystyrene are totally different from each other with respect to the reactivity, and therefore it is difficult to introduce an arm comprising a vinyl ether polymer and an arm comprising an oxystyrene polymer at the same time, and thus a star polymer having both an arm comprising a vinyl ether polymer and an arm comprising an oxystyrene polymer cannot be obtained by a core-first method. Further, the core-first method has problems in that a synthesis of a multifunctional initiator species is complicated, and in that the number of the arms is the same as the number of the functional groups and hence controlling of the number of the arms is difficult.
On the other hand, even when the synthesis method for a heteroarm star polymer of non-patent document 1 is applied to the vinyl ether and oxystyrene, due to the above-mentioned difference of the reactivity between the vinyl ether polymer and the oxystyrene polymer, a star polymer having both the vinyl ether polymer and the oxystyrene polymer cannot be obtained. Further, in non-patent document 1, the reaction of divinyl ether is checked by monitoring the amount of the consumed divinyl ether by measurement of gas chromatography (GC), but by such a method, a point in time that the crosslinking reaction is completed cannot be confirmed, causing a problem that the vinyl groups of the divinyl ether remain unreacted.
Therefore, the development of a star polymer having both an arm comprising a vinyl ether polymer and an arm comprising an oxystyrene polymer and a process for producing the same with ease has been desired.

Related Art References

Patent documents

Patent document 1: JP-A-2006-45550
Patent document 2: JP-A-2007-86516
Patent document 3: JP-A-2001-139647
Patent document 4: Japanese Patent No. 2782000
Patent document 5: JP-A-2005-154497
Patent document 6: JP-A-6-239944

Non-patent document

Non-patent document 1: "Macromolecules", vol. 26, pp. 254 to 259, 1993

Summary of the Invention

Problems that the Invention is to Solve

A task of the present invention is to provide a vinyl ether-based star polymer which comprises an arm comprising a vinyl ether polymer and an arm comprising an oxystyrene polymer, and a process for producing the star polymer, which can be continuously carried out in a series of steps.

Means for Solving the Problems

In this situation, the present inventors have made extensive and intensive studies. As a result, it has been found that a novel vinyl ether-based star polymer can be obtained by subjecting a vinyl ether to living cationic polymerization using an initiator species in the presence of a Lewis acid to form a portion constituting an arm of a star polymer, and then adding a divinyl ether to the resultant living polymer to effect a reaction, forming a core of the star polymer, and then, permitting an oxystyrene to extend from the core in the presence of a Lewis acid different from that used above, and the present invention has been completed.
Specifically, the invention is directed to a vinyl ether-based star polymer including a core and polymer-chain arm portions extending from the core, having an arm portion including vinyl ether repeating units and an arm portion including oxystyrene repeating units.
Further, the invention is the vinyl ether-based star polymer, wherein the vinyl ether repeating units of the arm portion are each represented by the following general formula (1):

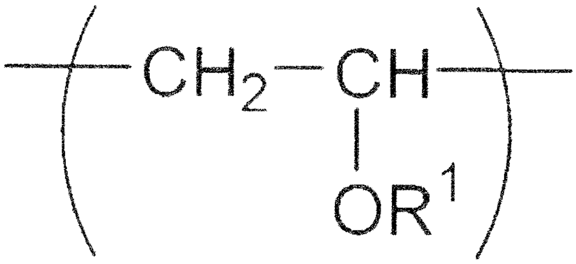

(1)

wherein $R^1$ represents a linear or branched alkyl group having 1 to 6 carbon atoms, a fluoroalkyl group which is a linear or branched alkyl group having 1 to 6 carbon atoms and having hydrogens, all of or part of which are or is replaced by fluorines or fluorine, an alkoxyalkyl group having 2 to 6 carbon atoms, a cycloalkyl group having 5 to 10 carbon atoms, an aryl group or arylalkyl group represented by the following group (a):

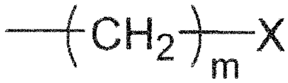

(a)

wherein m is 0, 1, 2, or 3, and X is an unsubstituted phenyl group or a phenyl group substituted with at least one: linear or branched alkyl group having 1 to 4 carbon atoms; fluoroalkyl group which is a linear or branched alkyl group having 1 to 4 carbon atoms and having hydrogens, all of or part of which are or is replaced by fluorines or fluorine; alkoxy group having 1 to 4 carbon atoms; or halogen atom,
or an alkoxypolyoxyalkyl group represented by the following group (b):

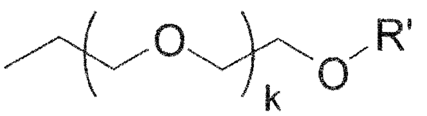

(b)

wherein R' represents a methyl group or an ethyl group, and k represents an integer of 1 to 10,
and the oxystyrene repeating units of the arm portion are each represented by the following general formula (2):

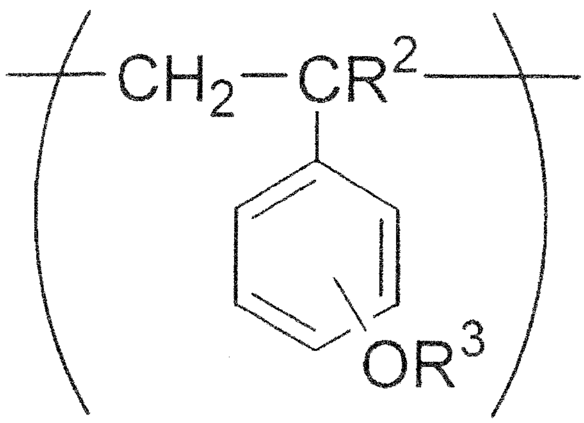

(2)

wherein $R^2$ represents a hydrogen atom or an alkyl group having 1 to 4 carbon atoms, and $R^3$ represents a hydrogen atom, an alkyl group having 1 to 4 carbon atoms, or an alkoxyalkyl group, acyl group, alkoxycarbonyl group, alkoxycarbonylalkyl group, or alkylsilyl group having 2 to 6 carbon atoms.

further, the invention is directed to a process for producing the above-mentioned vinyl ether-based star polymer,

including, subjecting a vinyl ether monomer represented by the following general formula (4) to living cationic polymerization in the presence of an initiator species, a Lewis acid suitable for cationic polymerization of a vinyl ether monomer, and a solvent:

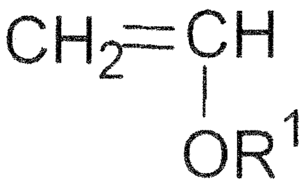

(4)

wherein $R^1$ is as defined above;

adding a divinyl compound represented by the following general formula (3) to introduce vinyl groups to the side chain:

$$CHR^4=CH\text{-}O\text{-}R^5\text{-}O\text{-}CH=CHR^6 \qquad (3)$$

wherein each of $R^4$ and $R^6$ represents a hydrogen atom or a methyl group, and $R^5$ represents a divalent organic group; permitting the vinyl groups to undergo intermolecular crosslinking to form a core;
adding an oxystyrene monomer represented by the following general formula (5) and a Lewis acid suitable for cationic polymerization of the oxystyrene monomer:

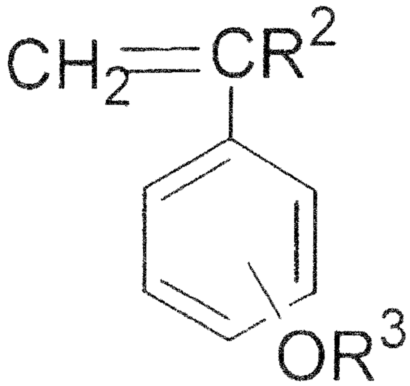

(5)

wherein $R^2$ and $R^3$ are as defined above.

Advantage of the Invention

The vinyl ether-based star polymer of the invention has a vinyl ether polymer and an oxystyrene polymer in the polymer-chain arms extending from the core, and therefore, in addition to the inherent properties of the star polymer, characteristic properties of the oxystyrene polymer and vinyl ether polymer can be imparted to the polymer.
Especially when the oxystyrene polymer is hydroxystyrene, in addition to characteristic properties of the star polymer, such as low viscosity and fine particle properties, development properties can be imparted to the star polymer, and therefore the star polymer of the invention can be preferably used as a raw material for a photosensitive resin component suitable for the use of an interlayer dielectric film, surface protecting film, or the like for a semiconductor device.
Further, the process for producing a vinyl ether-based star polymer of the present invention is commercially advantageous in that a polymerization reaction can be continuously performed in one pot for the reaction, making it possible to remarkably simplify the production steps and production facilities.

Mode for Carrying Out the Invention

Hereinbelow, the vinyl ether-based star polymer of the present invention and a process for producing the same will be described in detail.

In the star polymer of the invention, the vinyl ether repeating units represented by the general formula (1) above are formed from a vinyl ether monomer represented by the general formula (4) above.

In the definition of $R^1$ for the general formulae (1) and (4), examples of linear or branched alkyl groups having 1 to 6 carbon atoms include a methyl group, an ethyl group, a propyl group, an isopropyl group, a n-butyl group, a sec-butyl group, a tert-butyl group, an isobutyl group, a n-amyl group, and an isoamyl group, examples of fluoroalkyl groups having 1 to 6 carbon atoms include a trifluoromethyl group, a pentafluoroethyl group, and a 2,2,2-trifluoroethyl group, examples of alkoxyalkyl groups having 2 to 6 carbon atoms include a methoxymethyl group, an ethoxymethyl group, a 2-methoxyethyl group, a 2-ethoxyethyl group, a 2-tetrahydropyranyl group, and a 2-tetrahydrofuranyl group, and examples of cycloalkyl groups having 5 to 10 carbon atoms include a cyclopentyl group, a cyclohexyl group, a cycloheptyl group, a cyclooctyl group, a bicyclo[2.2.1]heptyl group, a bicyclo[2.2.2]octyl group, a tricyclo[5.2.1.0$^{2,6}$]decanyl group, and an adamantyl group. With respect to the group (a), examples of aryl groups include a phenyl group, a methylphenyl group, an ethylphenyl group, a methoxyphenyl group, an ethoxyphenyl group, a fluorophenyl group, and a trifluoromethylphenyl group, and examples of arylalkyl groups include a benzyl group, a methylbenzyl group, an ethylbenzyl group, a methoxybenzyl group, an ethoxybenzyl group, a fluorobenzyl group, and a trifluoromethylbenzyl group. Further, examples of alkoxypolyoxyalkyl groups represented by the group (b) include a 2-(2-methoxyethoxy)ethyl group, a 2-(2-ethoxyethoxy)ethyl group, a 2-[2-(2-methoxyethoxy)ethoxy]ethyl group, a 2-[2-(2-ethoxyethoxy)ethoxy]ethyl group, a 2-{2-[2-(2-methoxyethoxy)ethoxy]ethoxy}ethyl group, and a 2-{2-[2-(2-ethoxyethoxy)ethoxy]ethoxy}ethyl group.

Examples of vinyl ether monomers represented by the formula (4) above include alkyl vinyl ethers, such as methyl vinyl ether, ethyl vinyl ether, propyl vinyl ether, isopropyl vinyl ether, n-butyl vinyl ether, sec-butyl vinyl ether, tert-butyl vinyl ether, isobutyl vinyl ether, n-amyl vinyl ether, and isoamyl vinyl ether; fluoroalkyl vinyl ethers, such as trifluoromethyl vinyl ether, pentafluoroethyl vinyl ether, and 2,2,2-trifluoroethyl vinyl ether; alkoxyalkyl vinyl ethers, such as 2-methoxyethyl vinyl ether, 2-ethoxyethyl vinyl ether, 2-tetrahydropyranyl vinyl ether, and 2-tetrahydrofuranyl vinyl ether; cycloalkyl vinyl ethers, such as cyclopentyl vinyl ether, cyclohexyl vinyl ether, cycloheptyl vinyl ether, cyclooctyl vinyl ether, 2-bicyclo[2.2.1]heptyl vinyl ether, 2-bicyclo[2.2.2]octyl vinyl ether, 8-tricyclo[5.2.1.0$^{2,6}$]decanyl vinyl ether, 1-adamantyl vinyl ether, and 2-adamantyl vinyl ether; aryl vinyl ethers, such as phenyl vinyl ether, 4-methylphenyl vinyl ether, 4-trifluoromethylphenyl vinyl ether, and 4-fluorophenyl vinyl ether; arylalkyl vinyl ethers, such as benzyl vinyl ether and 4-fluorobenzyl vinyl ether; and alkoxypolyoxyalkyl vinyl ethers, such as 2-(2-methoxyethoxy)ethyl vinyl ether, 2-(2-ethoxyethoxy)ethyl vinyl ether, 2-[2-(2-methoxyethoxy)ethoxy]ethyl vinyl ether, and 2-[2-(2-ethoxyethoxy)ethoxy]ethyl vinyl ether.

Particularly, when polyvinyl ether is introduced as a soft segment for improving the oxystyrene polymer in flexibility and impact resistance, there can be preferably used methyl vinyl ether, ethyl vinyl ether, propyl vinyl ether, isopropyl vinyl ether, n-butyl vinyl ether, sec-butyl vinyl ether, tert-butyl vinyl ether, isobutyl vinyl ether, n-amyl vinyl ether, isoamyl vinyl ether, trifluoromethyl vinyl ether, pentafluoroethyl vinyl ether, 2,2,2-trifluoroethyl vinyl ether, 2-methoxyethyl vinyl ether, 2-ethoxyethyl vinyl ether, 2-(2-methoxyethoxy)ethyl vinyl ether, 2-(2-ethoxyethoxy)ethyl vinyl ether, 2-[2-(2-methoxyethoxy)ethoxy]ethyl vinyl ether, 2-[2-(2-ethoxyethoxy)ethoxy]ethyl vinyl ether, or the like. Especially, there can be preferably used a lower-alkyl vinyl ether, such as methyl vinyl ether, ethyl vinyl ether, propyl vinyl ether, isopropyl vinyl ether, n-butyl vinyl ether, sec-butyl vinyl ether, tert-butyl vinyl ether, isobutyl vinyl ether, n-amyl vinyl ether, or isoamyl vinyl ether.

On the other hand, in the star polymer of the invention, the oxystyrene repeating units represented by the general formula (2) above are formed from an oxystyrene monomer represented by the general formula (5) above.

In the definition of $R^2$ for the general formulae (2) and (5) , examples of alkyl groups having 1 to 4 carbon atoms include a methyl group, an ethyl group, a propyl group, an isopropyl group, a n-butyl group, a sec-butyl group, a tert-butyl group, and an isobutyl group.

Further, in the definition of $R^3$ for the general formulae (2) and (5), examples of alkyl groups having 1 to 6 carbon atoms include a methyl group, an ethyl group, a propyl group, an isopropyl group, a n-butyl group, a sec-butyl group, a tert-butyl group, an isobutyl group, a n-amyl group, and an isoamyl group, examples of alkoxyalkyl groups having 2 to 6 carbon atoms include a methoxymethyl group, an ethoxymethyl group, a 1-methoxyethyl group, a 1-ethoxyethyl group, a 1-methoxypropyl group, a 2-tetrahydropyranyl group, and a 2-tetrahydrofuranyl group, examples of acyl groups having 2 to 6 carbon atoms include an acetyl group, a propionyl group, and a tert-butylcarbonyl group, examples of alkoxycarbonyl groups having 2 to 6 carbon atoms include a methoxycarbonyl group, an ethoxycarbonyl group, a propoxycarbonyl group, and a tert-butoxycarbonyl group, examples of alkoxycarbonylalkyl groups having 2 to 6 carbon atoms include a tert-butoxycarbonylmethyl group, and examples of alkylsilyl groups having 2 to 6 carbon atoms include a trimethylsilyl group and a tert-butyldimethylsilyl group.

Each of the above substituents easily leaves due to an acid or an alkali to give a hydroxyl group, and therefore by deprotecting the obtained star polymer, a star polymer having hydroxystyrene repeating units in the arm can also be obtained.

Examples of oxystyrene monomers represented by the general formula (5) above include hydroxystyrenes, such as p-hydroxystyrene, m-hydroxystyrene, o-hydroxystyrene, p-isopropenylphenol, m-isopropenylphenol, and o-isopropenylphenol; alkoxystyrenes, such as p-methoxystyrene, m-methoxystyrene, p-ethoxystyrene, m-ethoxystyrene, p-propoxystyrene, m-propoxystyrene, p-isopropoxystyrene, m-isopropoxystyrene, p-n-butoxystyrene, m-n-butoxystyrene, p-isobutoxystyrene, m-isobutoxystyrene, p-tert-butoxystyrene, and m-tert-butoxystyrene; alkoxyalkyloxystyrenes, such as p-methoxymethoxystyrene, m-methoxymethoxystyrene, p-(1-ethoxyethoxy)styrene, m-(1-ethoxyethoxy)styrene, p-(2-tetrahydropyranyl)oxystyrene, and m-(2-tetrahydropyranyl)oxystyrene; alkanoyloxystyrenes, such as p-acetoxystyrene, m-acetoxystyrene, p-tert-butylcarbonyloxystyrene, and m-tert-butylcarbonyloxystyrene; alkoxycarbonyloxystyrenes, such as p-methoxycarbonyloxystyrene, m-methoxycarbonyloxystyrene, p-tert-butoxycarbonyloxystyrene, and m-tert-butoxycarbonylmethyloxystyrene; alkoxycarbonylalkyloxystyrenes, such as p-tert-butoxycarbonylmethyloxystyrene and m-tert-butoxycarbonylmethyloxystyrene; and alkylsilyloxystyrenes, such as p-trimethylsilyloxystyrene, m-trimethylsilyloxystyrene, p-tert-butyldimethylsilyloxystyrene, and m-tert-butyldimethylsilyloxystyrene.

Of these, p-hydroxystyrene, p-isopropenylphenol, p-tert-butoxystyrene, p-acetoxystyrene, or the like is preferably used.

With respect to the above-mentioned oxystyrene monomers and vinyl ether monomers, the respective monomers may be used individually or in combination.

With respect to the core of the star polymer of the invention, a multifunctional coupling agent can be preferably used, and especially preferred is a core having a structure formed by polymerization crosslinking of a multifunctional coupling agent.

As an example of the multifunctional coupling agent, there can be mentioned a divinyl ether represented by the general formula (3) above. In the general formula (3), each of $R^4$ and $R^6$ represents a hydrogen atom or a methyl group, and $R^5$ represents a divalent organic group. Examples of divalent organic groups $R^5$ include groups represented by the following formulae.

$$-\left(CH_2\right)_n-$$

$$-\left(CH_2\right)_l-R^7-\left(CH_2\right)_p-$$

wherein each of n, 1, and p represents an integer of 1 or more, and $R^7$ represents -O-, -O-Ph-O-, -O-Ph-$C(CH_3)_2$-Ph-O-, or a cycloalkyl group having 3 carbon atoms or more, wherein Ph represents a phenylene group.

Examples of divinyl ethers of the formula (3) above include ethylene glycol divinyl ether, bisphenol A bis (vinyloxyethylene) ether, bis(vinyloxyethylene) ether, hydroquinone bis(vinyloxyethylene) ether, and 1,4-bis(vinyloxymethyl)cyclohexane.

In the star polymer of the invention, the molecular weight is appropriately selected depending on the use or purpose of the polymer or the function to be exhibited, but, for example, when the star polymer of the invention is used as a raw material for a photosensitive resin component suitable for the use of an interlayer dielectric film, surface protecting film, or the like for a semiconductor device, the weight average molecular weight (Mw), as measured by a gel permeation chromatography method in terms of the standard polystyrene, is preferably 1,000 to 100, 000, more preferably 2,000 to 80,000, further preferably 4,000 to 60,000. The molecular weight distribution (Mw/Mn), in terms of a ratio of the weight average molecular weight (Mw) to the number average molecular weight (Mn), is preferably 1.0 to 2.0, more preferably 1.0 to 1.8, further preferably 1.0 to 1.6. When the Mw is larger than the above range, the solubility in a solvent or alkaline developer used in the film formation becomes poor, and when the Mw is smaller than the above range, the film forming performance is likely to be poor.

The production of the star polymer of the invention can be conducted by subjecting a vinyl ether monomer represented by the general formula (4) above to living cationic polymerization in the presence of an initiator species, a Lewis acid, and a solvent, and then, adding thereto a divinyl ether represented by the general formula (3) above to form a core, and then adding thereto an oxystyrene monomer represented by the general formula (5) above to effect a living cationic polymerization in the presence of a Lewis acid different from the first Lewis acid.

The initiator species usable in the invention include compounds capable of generating protons, such as water, an alcohol, and a protonic acid, and compounds capable of generating carbocations, such as an alkyl halide. Further,

cation donating compounds, such as an addition product of the vinyl ether and a compound capable of generating protons, are included. Examples of such compounds capable of generating carbocations include 1-alkoxyethyl acetates, such as 1-isobutoxyethyl acetate.

With respect to the amount of the initiator species added, there is no particular limitation, and the amount is appropriately determined according to a desired molecular weight of the polymer.

As a Lewis acid used in the living cationic polymerization reaction, a Lewis acid generally used in cationic polymerization of a vinyl ether monomer or oxystyrene monomer can be used. Specifically, for example, an organometal halide, such as $Et_{1.5}AlCl_{1.5}$, or a metal halide, such as $TiCl_4$, $TiBr_4$, $BCl_3$, $BF_3$, $BF_3{\bullet}OEt_2$, $SnCl_2$, $SnCl_4$, $SbCl_5$, $SbF_5$, $WCl_6$, $TaCl_5$, $VCl_5$, $FeCl_3$, $ZnBr_2$, $ZnCl_4$, $AlCl_3$, or $AlBr_3$, can be preferably used. These Lewis acids may be used individually, or in combination.

By the way, the vinyl ether monomer and the oxystyrene monomer are totally different from each other with respect to the reactivity in cationic polymerization, and therefore it is necessary that a Lewis acid used in the polymerization of the vinyl ether monomer (hereinafter, referred to as "Lewis acid (I)") and a Lewis acid used in the polymerization of the oxystyrene monomer (hereinafter, referred to as "Lewis acid (II)") be different from each other and selected according to the reactivity of the respective monomers. That is, the polymerization rate of the vinyl ether monomer or oxystyrene monomer depends on the acidity of a Lewis acid, the interaction between a Lewis acid and a stable base, the affinity between a Lewis acid and chlorine, or the like, and therefore it is important to select an appropriate Lewis acid in each polymerization reaction.

Examples of the Lewis acids (I) include organoaluminum halide compounds and aluminum halide compounds, each represented by the following general formula (6):

$$R^7_qAlY_r \qquad (6)$$

wherein $R^7$ represents a monovalent organic group, Y represents a halogen atom, and q and r represent numbers which satisfy the relationships: $q + r = 3$, $0 \le q < 3$, and $0 < r \le 3$.

In the definition of $R^7$ for the general formula (6), examples of monovalent organic groups include an alkyl group, an aryl group, an aralkyl group, an alkenyl group, and an alkoxy group, but they are not particularly limited. Examples of halogen atoms Y include a chlorine atom, a bromine atom, and a fluorine atom, and, with respect to q and r, it is preferred that q is in the range of from 1 to 2 and r is in the range of from 1 to 2.

Examples of the organoaluminum halide compounds and aluminum halide compounds represented by the general formula (6) above include diethylaluminum chloride, diethylaluminum bromide, diisobutylaluminum chloride, methylaluminum sesquichloride, ethylaluminum sesquichloride, ethylaluminum sesquibromide, isobutylaluminum sesquichloride, methylaluminum dichloride, ethylaluminum dichloride, ethylaluminum dibromide, ethylaluminum difluoride, isobutylaluminum dichloride, octylaluminum dichloride, ethoxyaluminum dichloride, and phenylaluminum dichloride.

On the other hand, examples of the Lewis acids (II) include metal halide compounds and organometal halide compounds, each comprising an element other than Al, and examples of these compounds include $TiCl_4$, $TiBr_4$, $BCl_3$, $BF_3$, $BF_3{\bullet}OEt_2$, $SnCl_2$, $SnCl_4$, $SbCl_5$, $SbF_5$, $WCl_6$, $TaCl_5$, $VCl_5$, $FeCl_3$, $ZnBr_2$, and $ZrCl_4$. Of these, as the Lewis acid (II), $SnCl_4$, $FeCl_3$, or the like is preferably used.

For example, by using $Et_{1.5}AlCl_{1.5}$ as a Lewis acid in the polymerization of a vinyl ether and then using $SnCl_4$ added in the polymerization of an oxystyrene to increase the polymerization rate of the oxystyrene component, a star polymer having both a vinyl ether arm and an oxystyrene arm can be produced.

With respect to the amount of the Lewis acid used, there is no particular limitation, but the amount can be selected taking into consideration the polymerization properties or polymerization concentration of the vinyl ether monomer and oxystyrene monomer used. The Lewis acid can be generally used in an amount of 0.1 to 100 mol%, preferably in the range of from 1 to 50 mol%, based on the mole of each monomer.

Examples of solvents for the above-mentioned polymerization reaction include aromatic hydrocarbon solvents, such as benzene, toluene, and xylene; aliphatic hydrocarbon solvents, such as propane, n-butane, isobutane, n-pentane, n-hexane, n-heptane, n-octane, isooctane, decane, hexadecane, and isopentane; hydrocarbon halide solvents, such as methylene chloride, ethylene chloride, and carbon tetrachloride; and ether solvents, such as tetrahydrofuran (THF), dioxane, diethyl ether, dibutyl ether, and ethylene glycol diethyl ether. Of these solvents, toluene, methylene chloride, or hexane is preferably used. These solvents may be used individually or in combination.

A specific polymerization reaction is conducted as follows. First, an initiator species, a solvent, and a vinyl ether monomer are successively placed in a reaction vessel, and then a Lewis acid (I) is added to the resultant mixture. In this step, a vinyl ether arm is first synthesized. Then, at a point in time when the conversion of the vinyl ether monomer is completed, a divinyl ether is added to the reaction mixture to introduce vinyl groups to the side chain, and the vinyl groups are permitted to undergo intermolecular crosslinking to form a core. Finally, at a point in time when the crosslinking reaction is completed, an oxystyrene monomer is added to the reaction mixture, and further a Lewis acid (II) is added thereto so that an oxyethylene arm extends from the core. These polymerization reactions can be continuously conducted

in the same reaction vessel in a series of steps.

The conditions for each polymerization vary depending on the types of the Lewis acid, initiator species, monomer, solvent used, and the like, but the polymerization temperature is generally preferably in the range of from -80 to 150°C, more preferably in the range of from -78 to 80°C. The polymerization time is generally in the range of from 10 to 250 hours.

In the process of the formation of a core from the divinyl ether, it is important that the reaction is conducted until all the vinyl groups of the divinyl ether are consumed. Even if all of the divinyl ether is consumed in the polymerization reaction and bonded to the polymer chains, when the crosslinking reaction is unsatisfactory such that the vinyl groups remain unreacted, the Lewis acid (II) having a high activation effect, which is added together with the oxystyrene monomer, possibly causes an inter-core reaction, thus forming giant molecules or gel.

The end point of the crosslinking reaction can be confirmed by, for example, monitoring an RI chart measured by GPC at regular intervals to check that the GPC waveshape does not change any more.

After the polymerization reaction is terminated by adding a reaction terminator at a time when a desired polymerization degree is achieved and, if necessary, the catalyst residue including a metal compound or the like is removed, a desired star polymer can be isolated by <1> a method in which the volatile component is removed by evaporation from the polymer solution, <2> a method in which a large amount of a poor solvent is added to the polymer solution to cause precipitation of a polymer and the polymer is separated, or the like.

As a reaction terminator, a compound acting as an end terminator and/or a compound having an action of deactivating a Lewis acid, for example, an alcohol, such as methanol, ethanol, or propanol; an amine, such as dimethylamine or diethylamine; water; aqueous ammonia; or an aqueous solution of sodium hydroxide is used.

Examples of methods for removing the metal compound or the like used as a Lewis acid include a method of treating the reaction mixture with water or an aqueous solution containing an acid, such as hydrochloric acid, nitric acid, or sulfuric acid; a method of treating the reaction mixture with an inorganic oxide, such as silica gel, alumina, or silica-alumina; and a method of treating the reaction mixture with an ion-exchange resin. Taking into consideration the efficiency of the removal of the metal compound or the like, and the cost, a method of treating the reaction mixture using an ion-exchange resin is most preferred.

A cation-exchange resin is effective in the removal of metal ions. When there is a danger that the high acidity of a cation-exchange resin causes the obtained star polymer to undergo a hydrolysis and/or crosslinking reaction, so that the star polymer is reduced or increased in the molecular weight, a mixture of a cation-exchange resin and an anion-exchange resin (mixed bed ion-exchange resin) may be used as an ion-exchange resin.

Examples of cation-exchange resins include strongly acidic cation-exchange resins, such as Amberlist 15 DRY (trade name), manufactured by ORGANO CORPORATION, and DIAION SK1BH, SK104H, PK208H, PK216H, PK228H (trade name), manufactured by Mitsubishi Chemical Corporation. Examples of mixed bed ion-exchange resins include mixtures of a strongly acidic cation-exchange resin, such as Amberlist MSPS2-1•DRY (trade name), manufactured by ORGANO CORPORATION, and a weakly basic anion-exchange resin.

When deprotecting for the protecting group of the oxystyrene units is conducted to obtain a star polymer having a hydroxystyrene polymer in the arm, a reaction may be effected, for example, in a solvent in the presence of an acid catalyst, such as hydrochloric acid or sulfuric acid, or under alkaline conditions using an aqueous solution of sodium hydroxide or the like at a reaction temperature of 50 to 150°C for a reaction time of 1 to 30 hours to allow the protecting group to leave, forming a hydroxystyrene polymer.

## Examples

Hereinbelow, the present invention will be described in more detail with reference to the following Examples, which should not be construed as limiting the scope of the invention. Physical properties of the star polymers obtained in the Examples were evaluated by the following methods.

(1) Weight average molecular weight (Mw), number average molecular weight (Mn), and molecular weight distribution (Mw/Mn):

These were determined by a gel permeation chromatography (GPC) method using a calibration curve obtained with respect to the standard polystyrene (RI detector; column: LF-804 × 3, manufactured by Shodex; eluent: tetrahydrofuran).

(2) Absolute molecular weight (Mw absolute):

An absolute molecular weight was determined by a gel permeation chromatography (GPC)-viscosity method (RI detector; viscometer; column: KF-800D + KF-805L × 2, manufactured by Shodex; eluent: tetrahydrofuran).

(3) Number (f) of arms:

The number (f) of arms was determined by making a calculation in accordance with the following formula.

$$f = A \times B/C$$

A: Weight fraction of the arm forming monomer
B: Mw absolute (star)
C: Mw (arm)

(4) Particle diameter

A particle diameter was determined by analysis by dynamic light scattering (DLS)(manufactured by OTSUKA ELECTRONICS CO., LTD.)(eluent: tetrahydrofuran).

Example 1

Production (1) of ethyl vinyl ether-core-p-tert-butoxystyrene star polymer:

A glass vessel equipped with a three-way cock was prepared and purged with argon gas, and then the argon gas atmosphere was heated to remove water adsorbed on the inside of the glass vessel. 0.18 molar (hereinafter, abbreviated to "M") of ethyl vinyl ether (hereinafter, referred to as "EVE"), 3.9 M of ethyl acetate, 15 millimolar (hereinafter, abbreviated to "mM") of 1-isobutoxyethyl acetate, and 222 ml of toluene were added to the vessel and followed by cooling. After the temperature in the reaction system reached -10°C, a toluene solution of $Et_{1.5}AlCl_{1.5}$ (12 mM) was added to initiate a polymerization. At a point in time when the conversion of EVE was completed, a small amount of a sample was taken out from the reaction solution, and the reaction of the sample was terminated using methanol containing sodium methoxide. The analysis of the sample by gel permeation chromatography (hereinafter, abbreviated to "GPC") showed that the obtained EVE polymer was a monomodal polymer having: Mw = 1,500, and Mw/Mn = 1.12.

Then, 30 mM of 1,4-bis(vinyloxymethyl)cyclohexane (hereinafter, referred to as "CHDVE") was added to the reaction solution, and a reaction was performed at a reaction temperature of -10°C. The conversion of the vinyl groups of CHDVE was monitored using GPC at regular intervals, and at a point in time when the GPC waveshape became a fixed shape, a small amount of a sample was taken out from the reaction solution, and the reaction of the sample was terminated using methanol containing sodium methoxide. The analysis of the sample by GPC showed that the obtained EVE-core star polymer was a monomodal polymer having: Mw = 13, 100, and Mw/Mn = 1.25. Further, the analysis confirmed that in the chart of this polymer, the peak for the arm completely disappeared.

Then, 0.18 M of p-tert-butoxystyrene (hereinafter, referred to as "PTBOS) was added to the reaction solution, and a toluene solution of $SnCl_4$ (41 mM) was added thereto and a reaction was performed for 3 hours. 0.5 M of ammonia/methanol was added to the polymerization reaction system to terminate the reaction, thus obtaining a desired star polymer. The obtained star polymer was a monomodal polymer having: Mw = 20,300, and Mw/Mn = 1.32.

Further, the reaction mixture solution was passed through Celite and a filter having a pore diameter of 0.1 μm. Amberlist MSPS2-1•DRY (trade name, manufactured by ORGANO CORPORATION) was added in an amount of 7 wt% to the resultant polymerization mixture, and the mixture was stirred at room temperature for 2 hours, and then passed through a filter having a pore diameter of 1 μm. The resultant mixture was concentrated under a reduced pressure by means of an evaporator to obtain an ethyl vinyl ether-core-p-tert-butoxystyrene star polymer. The obtained polymer was a polymer having: Mw = 21,900, and Mw/Mn = 1.35. Further, with respect to the obtained polymer, an absolute molecular weight was measured by GPC-LALLS. As a result, it was found that the Mw absolute was 51,200, the number of arms determined based on the Mw absolute was 16, and the particle diameter was 7.2 nm. From the fact that a general weight average molecular weight is smaller, as compared to an absolute molecular weight measured by GPC-LALLS, it is apparent that the obtained polymer has a compact structure having a number of branches. Further, from the analysis for particle diameter, it is also apparent that the molecules are present in a state such that they are not in association. Therefore, the obtained polymer is a star polymer.

Example 2

Production (2) of ethyl vinyl ether-core-p-tert-butoxystyrene star polymer:

A glass vessel equipped with a three-way cock was prepared and purged with argon gas, and then the argon gas atmosphere was heated to remove water adsorbed on the inside of the glass vessel. 0.18 M of EVE, 3.9 M of ethyl acetate, 15 mM of 1-isobutoxyethyl acetate, and 222 ml of toluene were added to the vessel and followed by cooling. After the temperature in the reaction system reached -20°C, a toluene solution of $Et_{1.5}AlCl_{1.5}$ (12 mM) was added to initiate a polymerization. At a point in time when the conversion of EVE was completed, a small amount of a sample was taken out from the reaction solution, and the reaction of the sample was terminated using methanol containing sodium methoxide. The analysis of the sample by GPC showed that the obtained EVE polymer was a monomodal polymer having: Mw = 1,500, and Mw/Mn = 1.11.

Then, 30 mM of CHDVE was added to the reaction solution, and a reaction was performed at a reaction temperature of -20°C. The conversion of the vinyl groups of CHDVE was monitored using GPC at regular intervals, and at a point in time when the GPC waveshape became a fixed shape, a small amount of a sample was taken out from the reaction solution, and the reaction of the sample was terminated using methanol containing sodium methoxide. The analysis of the sample by GPC showed that the obtained EVE-core star polymer was a monomodal polymer having: Mw = 12, 800, and Mw/Mn = 1.23. Further, the analysis confirmed that in the chart of this polymer, the peak for the arm completely disappeared.

Then, 0.18 M of PTBOS was added to the reaction solution, and a toluene solution of $SnCl_4$ (41 mM) was added thereto and a reaction was performed for 3 hours. 0.5 M of ammonia/methanol was added to the polymerization reaction system to terminate the reaction, thus obtaining a desired star polymer. The obtained star polymer was a monomodal polymer having: Mw = 13, 300, and Mw/Mn = 1.22.

Example 3

Production (3) of ethyl vinyl ether-core-p-tert-butoxystyrene star polymer:

A glass vessel equipped with a three-way cock was prepared and purged with argon gas, and then the argon gas atmosphere was heated to remove water adsorbed on the inside of the glass vessel. 0.18 M of EVE, 3.9 M of ethyl acetate, 15 mM of 1-isobutoxyethyl acetate, and 222 ml of toluene were added to the vessel and followed by cooling. After the temperature in the reaction system reached 0°C, a toluene solution of $Et_{1.5}AlCl_{1.5}$ (12 mM) was added to initiate a polymerization. At a point in time when the conversion of EVE was completed, a small amount of a sample was taken out from the reaction solution, and the reaction of the sample was terminated using methanol containing sodium methoxide. The analysis of the sample by GPC showed that the obtained EVE polymer was a monomodal polymer having: Mw = 1,700, and Mw/Mn = 1.20.

Then, 30 mM of CHDVE was added to the reaction solution, and a reaction was performed at a reaction temperature of 0°C. The conversion of the vinyl groups of CHDVE was monitored using GPC at regular intervals, and at a point in time when the GPC waveshape became a fixed shape, a small amount of a sample was taken out from the reaction solution, and the reaction of the sample was terminated using methanol containing sodium methoxide. The analysis of the sample by GPC showed that the obtained EVE-core star polymer was a monomodal polymer having: Mw = 17, 800, and Mw/Mn = 1.30. Further, the analysis confirmed that in the chart of this polymer, the peak for the arm completely disappeared.

Then, 0.18 M of PTBOS was added to the reaction solution, and a toluene solution of $SnCl_4$ (41 mM) was added thereto and a reaction was performed for 4 hours. 0.5 M of ammonia/methanol was added to the polymerization reaction system to terminate the reaction, thus obtaining a desired star polymer. The obtained star polymer was a monomodal polymer having: Mw = 25, 600, and Mw/Mn = 1.56.

Example 4

Production (1) of ethyl vinyl ether-core-p-isopropenylphenol star polymer:

A glass vessel equipped with a three-way cock was prepared and purged with argon gas, and then the argon gas atmosphere was heated to remove water adsorbed on the inside of the glass vessel. 0.19 M of EVE, 4.3 M of ethyl acetate, 17 mM of 1-isobutoxyethyl acetate, and 222 ml of toluene were added to the vessel and followed by cooling. After the temperature in the reaction system reached -20°C, a toluene solution of $Et_{1.5}AlCl_{1.5}$ (13 mM) was added to initiate a polymerization. At a point in time when the conversion of EVE was completed, a small amount of a sample was taken out from the reaction solution, and the reaction of the sample was terminated using methanol containing

sodium methoxide. The analysis of the sample by GPC showed that the obtained EVE polymer was a monomodal polymer having: Mw = 1,700, and Mw/Mn = 1.10.

Then, 33 mM of CHDVE was added to the reaction solution, and a reaction was performed at a reaction temperature of -20°C. The conversion of the vinyl groups of CHDVE was monitored using GPC at regular intervals, and at a point in time when the GPC waveshape became a fixed shape, a small amount of a sample was taken out from the reaction solution, and the reaction of the sample was terminated using methanol containing sodium methoxide. The analysis of the sample by GPC showed that the obtained EVE-core star polymer was a monomodal polymer having: Mw = 13, 400, and Mw/Mn = 1.22. Further, the analysis confirmed that in the chart of this polymer, the peak for the arm completely disappeared.

Then, an ethyl acetate solution of p-isopropenylphenol (hereinafter, referred to as "PIPP") (34 mM) was added to the reaction solution, and a toluene solution of $SnCl_4$ (8.9 mM) was added thereto and a reaction was performed for 24 hours. 0.5 M of ammonia/methanol was added to the polymerization reaction system to terminate the reaction, thus obtaining a desired star polymer. The obtained star polymer was a monomodal polymer having: Mw = 16,100, and Mw/Mn = 1.23.

Example 5

Production (2) of ethyl vinyl ether-core-p-isopropenylphenol star polymer:

A glass vessel equipped with a three-way cock was prepared and purged with argon gas, and then the argon gas atmosphere was heated to remove water adsorbed on the inside of the glass vessel. 0.36 M of EVE, 4.0 M of ethyl acetate, 32 mM of 1-isobutoxyethyl acetate, and 222 ml of toluene were added to the vessel and followed by cooling. After the temperature in the reaction system reached -20°C, a toluene solution of $Et_{1.5}AlCl_{1.5}$ (25 mM) was added to initiate a polymerization. At a point in time when the conversion of EVE was completed, a small amount of a sample was taken out from the reaction solution, and the reaction of the sample was terminated using methanol containing sodium methoxide. The analysis of the sample by GPC showed that the obtained EVE polymer was a monomodal polymer having: Mw = 1,600, and Mw/Mn = 1.15.

Then, 63 mM of CHDVE was added to the reaction solution, and a reaction was performed at a reaction temperature of -20°C. The conversion of the vinyl groups of CHDVE was monitored using GPC at regular intervals, and at a point in time when the GPC waveshape became a fixed shape, a small amount of a sample was taken out from the reaction solution, and the reaction of the sample was terminated using methanol containing sodium methoxide. The analysis of the sample by GPC showed that the obtained EVE-core star polymer was a monomodal polymer having: Mw = 20,700, and Mw/Mn = 1.37. Further, the analysis confirmed that in the chart of this polymer, the peak for the arm completely disappeared.

Then, an ethyl acetate solution of PIPP (64 mM) was added to the reaction solution, and a toluene solution of $SnCl_4$ (24.7 mM) was added thereto and a reaction was performed for 3 hours. 0.5 M of ammonia/methanol was added to the polymerization reaction system to terminate the reaction, thus obtaining a desired star polymer. The obtained star polymer was a monomodal polymer having: Mw = 17,800, and Mw/Mn = 1.31.

Example 6

Production (1) of methoxyethyl vinyl

ether-core-p-tert-butoxystyrene star polymer:

A glass vessel equipped with a three-way cock was prepared and purged with argon gas, and then the argon gas atmosphere was heated to remove water adsorbed on the inside of the glass vessel. 0.17 M of methoxyethyl vinyl ether (hereinafter, referred to as "MOVE"), 4.0 M of ethyl acetate, 15 mM of 1-isobutoxyethyl acetate, and 222 ml of toluene were added to the vessel and followed by cooling. After the temperature in the reaction system reached -10°C, a toluene solution of $Et_{1.5}AlCl_{1.5}$ (12 mM) was added to initiate a polymerization. At a point in time when the conversion of MOVE was completed, a small amount of a sample was taken out from the reaction solution, and the reaction of the sample was terminated using methanol containing sodium methoxide. The analysis of the sample by GPC showed that the obtained MOVE polymer was a monomodal polymer having: Mw = 1,700, and Mw/Mn = 1.19.

Then, 30 mM of CHDVE was added to the reaction solution, and a reaction was performed at a reaction temperature of -10°C. The conversion of the vinyl groups of CHDVE was monitored using GPC at regular intervals, and at a point in time when the GPC waveshape became a fixed shape, a small amount of a sample was taken out from the reaction solution, and the reaction of the sample was terminated using methanol containing sodium methoxide. The analysis of the sample by GPC showed that the obtained MOVE-core star polymer was a monomodal polymer having:

Mw = 12,100, and Mw/Mn = 1.23. Further, the analysis confirmed that in the chart of this polymer, the peak for the arm completely disappeared.

Then, 0.17 M of PTBOS was added to the reaction solution, and a toluene solution of $SnCl_4$ (41 mM) was added thereto and a reaction was performed for 7 hours. 0.5 M of ammonia/methanol was added to the polymerization reaction system to terminate the reaction, thus obtaining a desired star polymer. The obtained star polymer was a monomodal polymer having: Mw = 19, 600, and Mw/Mn = 1.35.

Example 7

Production of 2-[2-(2-methoxyethoxy)ethoxy]ethyl vinyl ether-core-p-isopropenylphenol star polymer:

A glass vessel equipped with a three-way cock was prepared and purged with argon gas, and then the argon gas atmosphere was heated to remove water adsorbed on the inside of the glass vessel. 0.18 M of 2-[2-(2-methoxyethoxy) ethoxy]ethyl vinyl ether (hereinafter, referred to as "MOEOEOVE"), 4.26 M of ethyl acetate, 16.9 mM of 1-isobutoxyethyl acetate, and 222 ml of toluene were added to the vessel and followed by cooling. After the temperature in the reaction system reached -10°C, a toluene solution of $Et_{1.5}AlCl_{1.5}$ (13.2 mM) was added to initiate a polymerization. At a point in time when the conversion of MOEOEOVE was completed, a small amount of a sample was taken out from the reaction solution, and the reaction of the sample was terminated using methanol containing sodium methoxide. The analysis of the sample by GPC showed that the obtained MOEOEOVE polymer was a monomodal polymer having: Mw = 3,800, and Mw/Mn = 1.18.

Then, 33 mM of CHDVE was added to the reaction solution, and a reaction was performed at a reaction temperature of -10°C. The conversion of the vinyl groups of CHDVE was monitored using GPC at regular intervals, and at a point in time when the GPC waveshape became a fixed shape, a small amount of a sample was taken out from the reaction solution, and the reaction of the sample was terminated using methanol containing sodium methoxide. The analysis of the sample by GPC showed that the obtained MOEOEOVE-core star polymer was a monomodal polymer having: Mw = 13,400, and Mw/Mn = 1.27. Further, the analysis confirmed that in the chart of this polymer, the peak for the arm completely disappeared.

Then, an ethyl acetate solution of PIPP (33 mM) was added to the reaction solution, and a toluene solution of $SnCl_4$ (53 mM) was added thereto and a reaction was performed for 5 hours. Methanol was added to the polymerization reaction system to terminate the reaction. The obtained polymer was a monomodal polymer having: Mw = 14,300, and Mw/Mn = 1.38.

Comparative Example 1.

Production (4) of ethyl vinyl ether-core-p-tert-butoxystyrene star polymer:

A glass vessel equipped with a three-way cock was prepared and purged with argon gas, and then the argon gas atmosphere was heated to remove water adsorbed on the inside of the glass vessel. 0.18 M of EVE, 3.9 M of ethyl acetate, 15 mM of 1-isobutoxyethyl acetate, and 222 ml of toluene were added to the vessel and followed by cooling. After the temperature in the reaction system reached -10°C, a toluene solution of $Et_{1.5}AlCl_{1.5}$ (12 mM) was added to initiate a polymerization. At a point in time when the conversion of EVE was completed, a small amount of a sample was taken out from the reaction solution, and the reaction of the sample was terminated using methanol containing sodium methoxide. The analysis of the sample by GPC showed that the obtained EVE polymer was a monomodal polymer having: Mw = 1,400, and Mw/Mn = 1.15.

Then, 30 mM of CHDVE was added to the reaction solution, and a reaction was performed at a reaction temperature of -10°C. The conversion of the vinyl groups of CHDVE was monitored using GPC at regular intervals, and at a point in time when the GPC waveshape became a fixed shape, a small amount of a sample was taken out from the reaction solution, and the reaction of the sample was terminated using methanol containing sodium methoxide. The analysis of the sample by GPC showed that the obtained EVE-core star polymer was a monomodal polymer having: Mw = 12, 900, and Mw/Mn = 1.24. Further, the analysis confirmed that in the chart of this polymer, the peak for the arm completely disappeared.

Then, 0.18 M of PTBOS was added to the reaction solution, and the reaction was continued without adding a Lewis acid. The conversion of PTBOS after 56 hours was 38%, that after 118 hours was 38%, and thus the conversion of PTBOS was fixed to a value of about 38%.

Comparative Example 2

Production (5) of ethyl vinyl ether-core-p-tert-butoxystyrene star polymer:

A glass vessel equipped with a three-way cock was prepared and purged with argon gas, and then the argon gas atmosphere was heated to remove water adsorbed on the inside of the glass vessel. 0.18 M of EVE, 3.9 M of ethyl acetate, 15 mM of 1-isobutoxyethyl acetate, and 222 ml of toluene were added to the vessel and followed by cooling. After the temperature in the reaction system reached 0°C, a toluene solution of $Et_{1.5}AlCl_{1.5}$ (12 mM) was added to initiate a polymerization. At a point in time when the conversion of EVE was completed, a small amount of a sample was taken out from the reaction solution, and the reaction of the sample was terminated using methanol containing sodium methoxide. The analysis of the sample by GPC showed that the obtained EVE polymer was a monomodal polymer having: Mw = 1,500, and Mw/Mn = 1.12.

Then, 78 mM of CHDVE was added to the reaction solution, and a reaction was performed at a reaction temperature of 0°C. The amount of the remaining CHDVE was monitored using GC at regular intervals, and at a point in time when all of the CHDVE was consumed as measured by GC, a small portion of a sample was taken out from the reaction solution, and the reaction of the sample was terminated using methanol containing sodium methoxide. The obtained polymer was a polymer having: Mw = 18,200, and Mw/Mn = 1.58.

Then, 0.18 M of PTBOS was added to the reaction solution, and a toluene solution of $SnCl_4$ (41 mM) was added thereto and a reaction was performed for 4 hours. 0.5 M of ammonia/methanol was added to the polymerization reaction system to terminate the reaction. The obtained polymer was a multimodal polymer having: Mw = 175,500, and Mw/Mn = 2.30.

As seen in Comparative Example 1, the vinyl ether monomer and the oxystyrene monomer are totally different from each other with respect to the cationic polymerizability, and hence when the Lewis acid used in the polymerization of the vinyl ether monomer is used as such in the polymerization of the oxystyrene monomer, the reaction of the oxystyrene monomer does substantially not proceed, so that the conversion is a fixed value. On the other hand, as seen in Examples 1 to 7, by further adding another Lewis acid capable of imparting a higher activity in the polymerization of the oxystyrene monomer, the polymerization reaction can be advanced.

Further, as seen in Comparative Example 2, in the process of the formation of a core from a divinyl ether, when an oxystyrene monomer and a Lewis acid are added while monitoring the amount of the consumed divinyl ether only by GC, a multimodal polymer having a large molecular weight is obtained, but a desired star polymer is not obtained. The reason for this is that the crosslinking reaction of the divinyl ether is not completed even when all of the divinyl ether are consumed, so that the vinyl groups remaining unreacted undergo a reaction due to the Lewis acid added together with the oxystyrene monomer, thus forming giant molecules or gel. In the production of the star polymer of the invention, the method of monitoring the crosslinking reaction by GPC as performed in Examples 1 to 7 is effective.

Industrial Applicability

The vinyl ether-based star polymer obtained by the present invention has a vinyl ether polymer and an oxystyrene polymer in the polymer-chain arms extending from the core, and has the inherent properties of the star polymer as well as characteristic properties of the oxystyrene polymer and vinyl ether polymer.

Especially when the oxystyrene polymer is hydroxystyrene, in addition to characteristic properties of the star polymer, such as low viscosity and fine particle properties, development properties can be imparted to the star polymer, and therefore the star polymer of the invention can be preferably used as a raw material for a photosensitive resin component suitable for the use of an interlayer dielectric film, surface protecting film, or the like for a semiconductor device.

Further, the process for producing a vinyl ether-based star polymer of the invention is commercially advantageous in that a polymerization reaction can be continuously performed in one pot for the reaction, making it possible to remarkably simplify the production steps and production facilities.

## Claims

1. A vinyl ether-based star polymer including a core and polymer-chain arm portions extending from the core, comprising an arm portion comprising vinyl ether repeating units and an arm portion comprising oxystyrene repeating units.

2. The vinyl ether-based star polymer according to claim 1, wherein the vinyl ether repeating units of the arm portion are each represented by the following general formula (1):

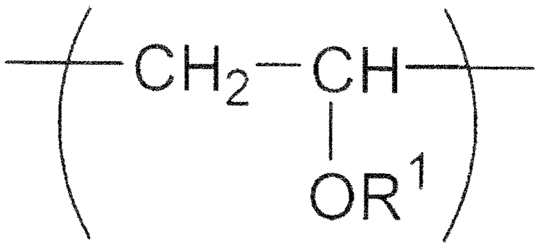

(1)

wherein $R^1$ represents a linear or branched alkyl group having 1 to 6 carbon atoms, a fluoroalkyl group which is a linear or branched alkyl group having 1 to 6 carbon atoms and having hydrogens, all of or part of which are or is replaced by fluorines or fluorine, an alkoxyalkyl group having 2 to 6 carbon atoms, a cycloalkyl group having 5 to 10 carbon atoms, an aryl group or arylalkyl group represented by the following group (a):

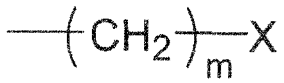

(a)

wherein m is 0, 1, 2, or 3, and X is an unsubstituted phenyl group or a phenyl group substituted with at least one: linear or branched alkyl group having 1 to 4 carbon atoms; fluoroalkyl group which is a linear or branched alkyl group having 1 to 4 carbon atoms and having hydrogens, all of or part of which are or is replaced by fluorines or fluorine; alkoxy group having 1 to 4 carbon atoms; or halogen atom,
or an alkoxypolyoxyalkyl group represented by the following group (b):

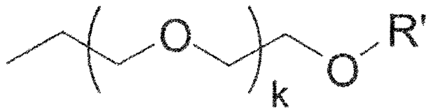

(b)

wherein R' represents a methyl group or an ethyl group, and k represents an integer of 1 to 10,
and the oxystyrene repeating units of the arm portion are each represented by the following general formula (2):

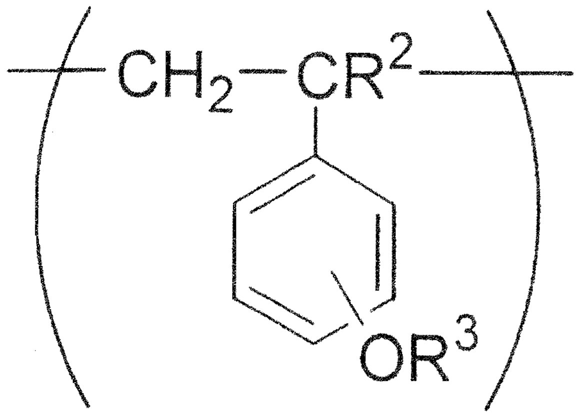

(2)

wherein $R^2$ represents a hydrogen atom or an alkyl group having 1 to 4 carbon atoms, and $R^3$ represents a hydrogen atom, an alkyl group having 1 to 4 carbon atoms, or an alkoxyalkyl group, acyl group, alkoxycarbonyl group, alkoxycarbonylalkyl group, or alkylsilyl group having 2 to 6 carbon atoms.

**3.** The vinyl ether-based star polymer according to claim 1 or 2, wherein the core is formed by crosslinking of a divinyl compound.

**4.** The vinyl ether-based star polymer according to claim 3, wherein the divinyl compound is a compound represented by the following general formula (3):

$$CHR^4=CH-O-R^5-O-CH=CHR^6 \qquad (3)$$

wherein each of $R^4$ and $R^6$ represents a hydrogen atom or a methyl group, and $R^5$ represents a divalent organic group.

**5.** The vinyl ether-based star polymer according to any one of claims 1 to 4, wherein the star polymer has a weight average molecular weight (Mw) in the range of from 5,000 to 200,000, as measured by gel permeation chromatography (GPC) in terms of the standard polystyrene, and a ratio of the weight average molecular weight (Mw) to the number average molecular weight (Mn)(Mw/Mn) of 1 to 2.

**6.** A process for producing a vinyl ether-based star polymer, comprising: subjecting a vinyl ether monomer represented by the following general formula (4) to living cationic polymerization in the presence of an initiator species, a Lewis acid suitable for cationic polymerization of a vinyl ether monomer, and a solvent:

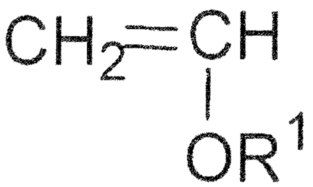

(4)

wherein $R^1$ represents a linear or branched alkyl group having 1 to 6 carbon atoms, a fluoroalkyl group which is a linear or branched alkyl group having 1 to 6 carbon atoms and having hydrogens, all of or part of which are or is replaced by fluorines or fluorine, an alkoxyalkyl group having 2 to 6 carbon atoms, a cycloalkyl group having 5 to 10 carbon atoms, an aryl group or arylalkyl group represented by the following group (a):

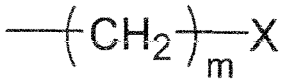

(a)

wherein m is 0, 1, 2, or 3, and X is an unsubstituted phenyl group or a phenyl group substituted with at least one: linear or branched alkyl group having 1 to 4 carbon atoms; fluoroalkyl group which is a linear or branched alkyl group having 1 to 4 carbon atoms and having hydrogens, all of or part of which are or is replaced by fluorines or fluorine; alkoxy group having 1 to 4 carbon atoms; or halogen atom,
or an alkoxypolyoxyalkyl group represented by the following group (b) :

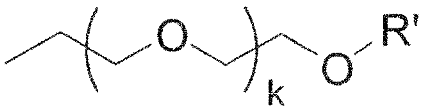

(b)

wherein R' represents a methyl group or an ethyl group, and k represents an integer of 1 to 10;

adding a divinyl compound represented by the following general formula (3) to introduce vinyl groups to the side chain:

$$CHR^4=CH-O-R^5-O-CH=CHR^6 \qquad (3)$$

wherein each of $R^4$ and $R^6$ represents a hydrogen atom or a methyl group, and $R^5$ represents a divalent organic group;
permitting the vinyl groups to undergo intermolecular crosslinking to form a core; and
adding an oxystyrene monomer represented by the following general formula (5) and a Lewis acid suitable for

cationic polymerization of the oxystyrene monomer to extend an oxystyrene arm from the core:

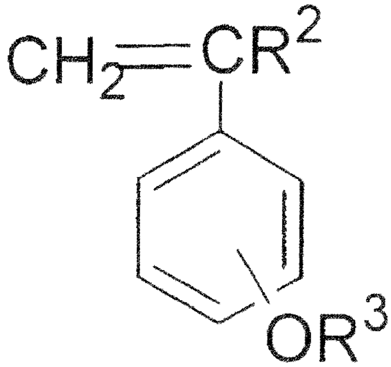

(5)

wherein $R^2$ represents a hydrogen atom or an alkyl group having 1 to 4 carbon atoms, and $R^3$ represents a hydrogen atom, an alkyl group having 1 to 4 carbon atoms, or an alkoxyalkyl group, acyl group, alkoxycarbonyl group, alkoxycarbonylalkyl group, or alkylsilyl group having 2 to 6 carbon atoms.

**7.** The process for producing a vinyl ether-based star polymer according to claim 6, wherein the Lewis acid suitable for cationic polymerization of the vinyl ether monomer is an organoaluminum halide compound or aluminum halide compound represented by the following general formula (6):

$$R^7_qAlY_r \qquad (6)$$

wherein $R^7$ represents a monovalent organic group, Y represents a halogen atom, and q and r represent numbers which satisfy the relationships: $q + r = 3$, $0 \leq q < 3$, and $0 < r \leq 3$,
and the Lewis acid suitable for cationic polymerization of the oxystyrene monomer is a metal halide compound or organometal halide compound comprising an element other than Al.

**8.** The process for producing a vinyl ether-based star polymer according to claim 6 or 7, wherein the formation of the core by intermolecular crosslinking is confirmed by monitoring the waveshape of a GPC chart.

## INTERNATIONAL SEARCH REPORT

International application No. PCT/JP2010/050121

A. CLASSIFICATION OF SUBJECT MATTER
*C08F293/00*(2006.01)i

According to International Patent Classification (IPC) or to both national classification and IPC

B. FIELDS SEARCHED

Minimum documentation searched (classification system followed by classification symbols)
C08F293/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)
CA/REGISTRY(STN)

C. DOCUMENTS CONSIDERED TO BE RELEVANT

| Category* | Citation of document, with indication, where appropriate, of the relevant passages | Relevant to claim No. |
|---|---|---|
| X<br>A | JP 2007-336790 A (Kuraray Co., Ltd.), 27 December 2007 (27.12.2007), claims; paragraphs [0020], [0027], [0030] & US 2008/0014505 A1 & EP 1870597 A2 | 1-2<br>3-8 |
| A | JP 2002-105153 A (Nippon Soda Co., Ltd.), 10 April 2002 (10.04.2002), entire text (Family: none) | 1-8 |
| A | JP 2005-154497 A (Japan Science and Technology Agency), 16 June 2005 (16.06.2005), entire text (Family: none) | 1-8 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>09 March, 2010 (09.03.10) | Date of mailing of the international search report<br>16 March, 2010 (16.03.10) |
| Name and mailing address of the ISA/<br>Japanese Patent Office<br>Facsimile No. | Authorized officer<br><br>Telephone No. |

Form PCT/ISA/210 (second sheet) (July 2009)

**INTERNATIONAL SEARCH REPORT**

International application No.
PCT/JP2010/050121

C (Continuation). DOCUMENTS CONSIDERED TO BE RELEVANT

| Category* | Citation of document, with indication, where appropriate, of the relevant passages | Relevant to claim No. |
|---|---|---|
| A | JP 2007-537323 A (Rhodia Chimie), 20 December 2007 (20.12.2007), entire text & US 2008/0114128 A1 & EP 1765895 A & WO 2005/116097 A1 & FR 2870245 A | 1-8 |
| A | WO 2007/029794 A1 (Nippon Soda Co., Ltd.), 15 March 2007 (15.03.2007), entire text & US 2009/0118436 A & EP 1923418 A1 & KR 10-2008-0034023 A & CN 101258184 A | 1-8 |
| A | JP 3-137114 A (Toshinobu HIGASHIMURA), 11 June 1991 (11.06.1991), claims (Family: none) | 1-8 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006045550 A
- JP 2007086516 A
- JP 2001139647 A
- JP 2782000 B
- JP 2005154497 A
- JP 6239944 A


### Non-patent literature cited in the description


- *Macromolecules,* 1993, vol. 26, 254-259